(19) Europäisches Patentamt
European Patent Office
Office européen des brevets

(11) **EP 4 231 807 A1**

(12) # EUROPEAN PATENT APPLICATION

(43) Date of publication:
**23.08.2023 Bulletin 2023/34**

(21) Application number: **23154669.8**

(22) Date of filing: **02.02.2023**

(51) International Patent Classification (IPC):
**H10N 30/076** (2023.01)     **H10N 30/00** (2023.01)
**H10N 30/853** (2023.01)     **H10N 30/87** (2023.01)

(52) Cooperative Patent Classification (CPC):
**H10N 30/8554; H10N 30/076; H10N 30/10513;
H10N 30/878**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.02.2022 JP 2022025867**

(71) Applicant: **FUJIFILM Corporation
Tokyo 106-8620 (JP)**

(72) Inventors:
• **MOCHIZUKI, Fumihiko
No. 577, Ushijima, Kaisei-machi,
Ashigarakami-gun,
Kanagawa, 258-8577 (JP)**

• **KOBAYASHI, Hiroyuki
No. 577, Ushijima, Kaisei-machi,
Ashigarakami-gun,
Kanagawa, 258-8577 (JP)**
• **MUKAIYAMA, Akihiro
No. 577, Ushijima, Kaisei-machi,
Ashigarakami-gun,
Kanagawa, 258-8577 (JP)**

(74) Representative: **HGF
HGF Limited
1 City Walk
Leeds LS11 9DX (GB)**

(54) **PIEZOELECTRIC LAMINATE, PIEZOELECTRIC ELEMENT, AND MANUFACTURING METHOD FOR PIEZOELECTRIC LAMINATE**

(57)     An object of the present invention is to provide a piezoelectric laminate and a piezoelectric element, which has excellent long-term reliability.

There is provided a piezoelectric laminate (5) including, on a substrate (10), in the following order, a lower electrode layer (12) and a piezoelectric film (15) containing a Pb-containing perovskite-type oxide, in which the piezoelectric film contains an oxygen atom $^{18}O$ having a mass number of 18 in oxygen as a constituent element in excess of a natural abundance ratio. There are also provided a piezoelectric laminate, a piezoelectric element, and a manufacturing method for a piezoelectric laminate.

FIG. 1

EP 4 231 807 A1

**Description**

**BACKGROUND OF THE INVENTION**

1. Field of the Invention

The present disclosure relates to a piezoelectric laminate, a piezoelectric element, and a manufacturing method for piezoelectric laminate.

2. Description of the Related Art

As a material having excellent piezoelectric characteristics and excellent ferroelectricity, there is known a perovskite-type oxide such as lead zirconate titanate ($Pb(Zr,Ti)O_3$, hereinafter referred to as PZT). A piezoelectric body consisting of a perovskite-type oxide is applied as a piezoelectric film in a piezoelectric element having a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and an oscillation power generation device.

In a case where the piezoelectric film is used for a memory, an actuator, a sensor, or the like, the stability (the long-term reliability) of piezoelectric characteristics in an operation environment is required in addition to a high piezoelectric constant.

The piezoelectric characteristics greatly change due to the excess or deficiency of oxygen in the perovskite structure of the perovskite-type oxide. In particular, in a perovskite-type oxide containing lead (Pb) such as a PZT film, oxygen is easily eliminated, and the oxygen defect in the piezoelectric film easily causes the temporal deterioration of piezoelectric characteristics. In order to improve the long-term reliability of the piezoelectric film, it is required to have a high dielectric breakdown voltage (withstand voltage).

Various methods for improving the dielectric breakdown voltage have been proposed for a piezoelectric film consisting of a perovskite-type oxide containing Pb. For example, JP2017-162906A discloses that an insulating layer consisting of a material different from a piezoelectric film is provided between the piezoelectric film and an electrode in order to increase the dielectric breakdown voltage. As the insulating layer, for example, silicon oxide ($SiO_2$), aluminum oxide ($Al_2O_3$), and magnesium oxide (MgO) are described.

Further, JP2006-86223A discloses a method of providing a metal oxide layer between an electrode and a piezoelectric film to compensate for oxygen pores in the piezoelectric film with oxygen in a metal oxide layer provided adjacent to the piezoelectric film, thereby suppressing the deterioration of piezoelectric characteristics.

**SUMMARY OF THE INVENTION**

According to the method of JP2017-162906A, the dielectric breakdown voltage can be increased. However, in a case where an insulating layer is provided between the piezoelectric film and the electrode, there is a problem that the piezoelectric constant is decreased as compared with a case where the insulating layer is not provided.

JP2006-86223A also has the same problem as that of JP2017-162906A in a case where the insulating layer is used as s metal oxide layer.

The technology according to the present disclosure has been made in consideration of the above circumstances, and a piezoelectric laminate, in which a piezoelectric film containing a Pb-containing perovskite-type oxide is included and the dielectric breakdown voltage is improved without decreasing the piezoelectric constant, a piezoelectric element, and a manufacturing method for a piezoelectric laminate are provided.

The piezoelectric laminate according to the present disclosure is a piezoelectric laminate comprising, on a substrate in the following order, a lower electrode layer and a piezoelectric film containing a Pb-containing perovskite-type oxide,

in which the piezoelectric film contains an oxygen atom $^{18}O$ having a mass number of 18 in oxygen as a constituent element in excess of a natural abundance ratio.

In the piezoelectric laminate according to the present disclosure, it is preferable that in the oxygen as the constituent element of the piezoelectric film, a ratio of the oxygen atom $^{18}O$ to a sum of an oxygen atom $^{16}O$ having a mass number of 16 and the oxygen atom $^{18}O$ is 1% or more.

In the piezoelectric laminate according to the present disclosure, it is preferable that in the oxygen as the constituent element of the piezoelectric film, a ratio of the oxygen atom $^{18}O$ to a sum of an oxygen atom $^{16}O$ having a mass number of 16 and the oxygen atom $^{18}O$ is 5% or more and 15% or less.

In the piezoelectric laminate according to the present disclosure, it is preferable that the perovskite-type oxide contains Zr, Ti, and O, in addition to Pb.

2

In the piezoelectric laminate according to the present disclosure, it is preferable that the perovskite-type oxide further contains Nb.

In the piezoelectric laminate according to the present disclosure, it is preferable that the perovskite-type oxide is a compound represented by General Formula (1).

$$Pb\{(Zr_xTi_{1-x})_{y-1}Nb_y\}O_3 \qquad (1)$$

$$0 < x < 1, \ 0.1 \le y \le 0.4$$

In the piezoelectric laminate according to the present disclosure, it is preferable that the piezoelectric film is a sputter film.

A piezoelectric element according to the present disclosure has the piezoelectric laminate according to the present disclosure and
an upper electrode layer provided on the piezoelectric film of the piezoelectric laminate.

A manufacturing method for a piezoelectric laminate according to the present disclosure is a manufacturing method for the piezoelectric laminate, comprising a sputtering step of forming the piezoelectric film through sputter film formation on the lower electrode layer formed on the substrate,
in which in the sputtering step, oxygen including an oxygen atom $^{18}O$ having a mass number of 18 at a ratio larger than a natural abundance ratio is allowed to flow as a part of a film forming gas.

According to the piezoelectric laminate, the piezoelectric element, and the manufacturing method for the piezoelectric laminate according to the present disclosure, a piezoelectric laminate, in which a piezoelectric film containing a Pb-containing perovskite-type oxide is included and the dielectric breakdown voltage is improved without decreasing the piezoelectric constant, and a piezoelectric element are obtained.

## BRIEF DESCRIPTION OF THE DRAWINGS

Fig. 1 is a cross-sectional view illustrating a layer configuration of a piezoelectric laminate and a piezoelectric element, according to a first embodiment.
Fig. 2 is a graph showing an oxygen profile in a piezoelectric film of Example 5.

## DESCRIPTION OF THE PREFERRED EMBODIMENTS

Hereinafter, embodiments according to the present invention will be described with reference to the drawings. In the drawings below, the layer thickness of each of the layers and the ratio therebetween are appropriately changed and drawn for easy visibility, and thus they do not necessarily reflect the actual layer thickness and ratio.

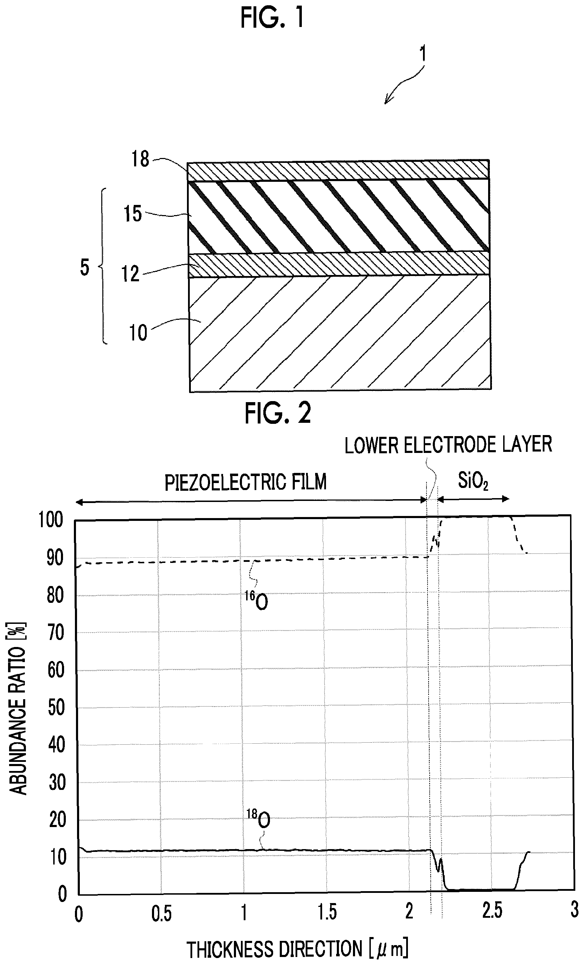

Piezoelectric laminate 5 and piezoelectric element 1 according to first embodiment Fig. 1 is a schematic cross-sectional view illustrating a layer configuration of a piezoelectric laminate 5 and a piezoelectric element 1 including the piezoelectric laminate 5, according to a first embodiment. As illustrated in Fig. 1, the piezoelectric element 1 has the piezoelectric laminate 5 and an upper electrode layer 18. The piezoelectric laminate 5 has a substrate 10, and a lower electrode layer 12 and a piezoelectric film 15 which are laminated on the substrate 10. Here, "lower" and "upper" do not respectively mean top and bottom in the vertical direction. As result, an electrode disposed on the side of the substrate 10 with the piezoelectric film 15 being interposed is merely referred to as the lower electrode layer 12, and an electrode disposed on the side of the piezoelectric film 15 opposite to the substrate 10 is merely referred to as the upper electrode layer 18.

In the piezoelectric laminate 5, the piezoelectric film 15 contains a Pb-containing perovskite-type oxide. It is preferable that the piezoelectric film 15 is occupied by 80% by mole or more of the Pb-containing perovskite-type oxide. Further, it is preferable that the piezoelectric film 15 is consisting of a Pb-containing perovskite-type oxide (however, it contains unavoidable impurities).

The perovskite-type oxide is represented by General Formula $ABO_3$. A represents an A site element, B represents a B site element, and O represents an oxygen element. A reference ratio is 1:1:3 for A:B:O; however, A:B:O may deviate within a range in which a perovskite structure is obtained.

The Pb-containing perovskite-type oxide is a perovskite-type oxide containing Pb as a main component of the A site. It is noted that in the present specification, "the main component" means a component of which the occupation is 50% by mole or more. That is, "containing Pb as a main component of the A site" means that among the A site elements, the component having 50% by mole or more is Pb. In the perovskite-type oxide containing Pb, the elements in the A site other than Pb and the elements of the B site are not particularly limited.

The A site element of the perovskite-type oxide may include one or two or more of barium (Ba), lanthanum (La), strontium (Sr), bismuth (Bi), lithium (Li), sodium (Na), calcium (Ca), cadmium (Cd), magnesium (Mg), and potassium (K), in addition to Pb.

The B site element B is one of titanium (Ti), zirconium (Zr), vanadium (V), niobium (Nb), tantalum (Ta), chromium (Cr), molybdenum (Mo), tungsten (W), manganese (Mn), iron (Fe), ruthenium (Ru), cobalt (Co), Ir, nickel (Ni), copper (Cu), zinc (Zn), gallium (Ga), indium (In), tin (Sn), antimony (Sb), or a lanthanide element, or a combination of two or more thereof.

The perovskite-type oxide is preferably a lead zirconate titanate (PZT) type that contains lead (Pb), zirconium (Zr), titanium (Ti), and oxygen (O).

In particular, it is preferable that the perovskite-type oxide is a compound represented by General Formula (P), which contains an additive B1 in the B site of PZT.

$$Pb\{(Zr_xTi_{1-x})_{1-y}B1_y\}O_3 \qquad (P)$$

Here, $0 < x < 1$ and $0 < y < 0.3$ are satisfied.

Examples of the B1 include scandium (Sc), V, Nb, Ta, Cr, Mo, W, Mn, Fe, Ru, Co, Ir, Ni, Cu, Zn, Ga, In, Sn, and Sb. It is preferable to contain one or more elements among these elements. B1 is more preferably any one of Sc, Nb, or Ni.

In particular, B1 is preferably Nb, and it is particularly preferably a compound represented by General Formula (1).

$$Pb\{(Zr_xTi_{1-x})_{y-1}Nb_y\}O_3 \qquad (1)$$

$$0 < x < 1,\ 0.1 \le y \le 0.4$$

The film thickness of the piezoelectric film 15 is not particularly limited, and it is generally 200 nm or more, for example, 0.2 $\mu$m to 5 $\mu$m. The film thickness of the piezoelectric film 15 is preferably 1 $\mu$m or more.

The piezoelectric film 15 contains an oxygen atom $^{18}O$ having a mass number of 18 in the oxygen among the constituent elements constituting the piezoelectric film 15 in excess of the natural abundance ratio. That is, the piezoelectric film 15 contains $^{18}O$ in excess of the natural abundance ratio, as an oxygen element constituting the perovskite-type oxide.

Examples of the stable isotope of oxygen include an oxygen atom $^{16}O$ having a mass number of 16, an oxygen atom $^{17}O$ having a mass number of 17, and an oxygen atom $^{18}O$ having a mass number of 18. The natural abundance ratios of $^{16}O$, $^{17}O$, and $^{18}O$ are respectively 99.757%, 0.038%, and 0.205%. As a result, "contains $^{18}O$ in excess of the natural abundance ratio" means that $^{18}O$ is contained in excess of 0.2%.

In the oxygen as the constituent element of the piezoelectric film 15, the ratio of the oxygen atom $^{18}O$ to the sum of the oxygen atom $^{16}O$ having a mass number of 16 and the oxygen atom $^{18}O$ is preferably 1% or more, more preferably 3% or more, still more preferably 5% or more, and particularly preferably 10% or more. The upper limit value of the $^{18}O$ content ratio is not limited; however, it is preferably 15% or less from the viewpoint of manufacturing cost.

In the oxygen as the constituent element of the piezoelectric film 15 in the piezoelectric film 15, the ratio of the oxygen atom $^{18}O$ to the sum of the oxygen atom $^{16}O$ having a mass number of 16 and the oxygen atom $^{18}O$ can be measured by the secondary ion mass spectrometry (SIMS) analysis. In the present disclosure, the ratio of the oxygen atom $^{18}O$ to the sum of the oxygen atom $^{16}O$ having a mass number of 16 and the oxygen atom $^{18}O$ is a value obtained from the data obtained by the SIMS analysis.

In the SIMS analysis, the distributions of $^{18}O$ and $^{16}O$ in the thickness direction of the piezoelectric film 15 can be measured (see Fig. 2). The ratio of $^{18}O$ to the sum of $^{16}O$ and $^{18}O$ is preferably more than 0.2% at each position in the thickness direction. However, it suffices that the ratio of $^{18}O$ to the sum of $^{16}O$ and $^{18}O$ in the entire region of the piezoelectric film 15 is more than 0.2% even in a case where a place where the ratio does not exceed 0.2% is present. Similarly, the description that the ratio of $^{18}O$ to the sum of $^{16}O$ and $^{18}O$ is 1% or more means that the ratio of $^{18}O$ to the sum of $^{16}O$ and $^{18}O$ in the entire region of the piezoelectric film 15 is 1% or more.

The substrate 10 is not particularly limited, and examples thereof include substrates such as silicon, glass, stainless steel, yttrium-stabilized zirconia, alumina, sapphire, and silicon carbide. As the substrate 10, a laminated substrate having a $SiO_2$ oxide film formed on the surface of the silicon substrate may be used.

The lower electrode layer 12 is paired with the upper electrode layer 18 and is an electrode for applying a voltage to the piezoelectric film 15. The main component of the lower electrode layer 12 is not particularly limited, and examples thereof include metals such as gold (Au), platinum (Pt), iridium (Ir), ruthenium (Ru), titanium (Ti), molybdenum (Mo), tantalum (Ta), aluminum (Al), copper (Cu), and silver (Ag), alloys such as TiW, and metal oxides, as well as combinations thereof. In addition, indium tin oxide (ITO), LaNiOs, $SrRuO_3$ (SRO), or the like may be used. Various intimate attachment layers or seed layers may be included between the lower electrode layer 12 and the substrate 10.

The layer thickness of the lower electrode layer 12 is not particularly limited, and it is preferably about 50 nm to 300 nm and more preferably 100 nm to 300 nm. It is noted that the lower electrode layer 12 is not limited to a single layer and may have a laminated structure consisting of a plurality of layers.

The upper electrode layer 18 is paired with the lower electrode layer 12 and is an electrode for applying a voltage to the piezoelectric film 15. As the main component of the upper electrode layer 18, the material described for the lower electrode layer 12 can be appropriately used. The upper electrode layer 18 may be a single layer or may have a laminated structure composed of a plurality of layers. It is noted that from the viewpoint of further suppressing oxygen diffusion from the piezoelectric film 15, at least a region of the upper electrode layer 18, which is in contact with the piezoelectric film 15, is preferably an oxide electrode.

The layer thickness of the upper electrode layer 18 is not particularly limited, and it is preferably about 50 nm to 300 nm and more preferably 100 nm to 300 nm.

As described above, in the piezoelectric laminate 5 and the piezoelectric element 1 according to the present embodiment, the piezoelectric film 15 contains an oxygen atom $^{18}$O having a mass number of 18 in the oxygen as a constituent element in excess of the natural abundance ratio. In a case where the piezoelectric film 15 contains the oxygen atom $^{18}$O in excess of the natural abundance ratio, it is possible to realize a high dielectric breakdown voltage without decreasing the piezoelectric constant as compared with a case where the oxygen atom $^{18}$O is present at the natural abundance ratio (see Examples). It is presumed that the oxygen atom $^{18}$O hardly causes oxygen defects in the perovskite-type structure as compared with the oxygen atom $^{16}$O having a mass number of 16, and the dielectric breakdown voltage is improved since the oxygen defects are suppressed. As described above, in the Pb-containing perovskite-type oxide, the deterioration of piezoelectric characteristics occurs due to the occurrence of oxygen defects, and thus the effect of the improvement of long-term reliability, which is obtained by increasing the ratio of the oxygen atom $^{18}$O in the oxygen, is high.

The piezoelectric element 1 or the piezoelectric laminate 5 according to each of the above embodiments can be applied to an ultrasonic device, a mirror device, a sensor, a memory, and the like.

The piezoelectric laminate 5 can be manufactured by forming the piezoelectric film 15 containing a Pb-containing perovskite-type oxide on the lower electrode layer 12 formed on the substrate 10, through sputter film formation. In this case, the piezoelectric film 15 is a sputter film formed through the sputter film formation.

The production method for the piezoelectric film 15, which contains a Pb-containing perovskite-type oxide containing the oxygen atom $^{18}$O in excess of the natural abundance ratio, is not particularly limited. As described above, the piezoelectric film containing a Pb-containing perovskite-type oxide can be formed through film formation by, for example, sputtering. As the film forming gas at the time of the sputter film formation, argon and oxygen are used. The general oxygen includes $^{18}$O having a natural abundance ratio of 0.2%. In a case where $^{18}$O is included at a ratio larger than the natural abundance ratio of 0.2%, in the oxygen to be allowed to flow as a film forming gas at the time of film formation, $^{18}$O can be contained at a ratio larger than the natural abundance ratio, in the piezoelectric film 15 which has been formed through the film formation. The ratio of $^{18}$O in the oxygen to be allowed to flow as a film forming gas is preferably 10% or more and more preferably 20% or more. The higher the ratio of $^{18}$O in the oxygen allowed to flow as the film forming gas is, the higher the ratio of $^{18}$O in the oxygen as the constituent element in the piezoelectric film 15 can be.

In addition, also in a case where a target containing $^{18}$O having a ratio exceeding the natural abundance ratio is used as the oxygen contained in a sputter target for preparing a composition of interest, and then sputter film formation is carried out, $^{18}$O can be contained at a ratio larger than the natural abundance ratio, in the piezoelectric film 15 which has been formed through the film formation. Furthermore, in a case where at least a part of the oxygen in the piezoelectric film 15 is replaced with $^{18}$O by annealing the piezoelectric film 15 which has been formed through the film formation using general oxygen, in the oxygen including $^{18}$O having a ratio exceeding the natural abundance ratio, it is possible to obtain the piezoelectric film 15 which contains $^{18}$O at a ratio larger than the natural abundance ratio. In addition, two or three of the above methods may be combined.

Among the production methods described above, the method in which $^{18}$O is included in the oxygen to be allowed to flow as a part of the film forming gas is the simplest. Examples

Hereinafter, specific examples and comparative examples of the piezoelectric element according to the present disclosure will be described. First, a production method for a piezoelectric element of each example will be described. It is noted that the production conditions other than the condition of the oxygen to be allowed to flow at the time of the formation of the piezoelectric film were the same in all Examples. In addition, a radio frequency (RF) sputtering device was used for the film formation of each layer.

Production method

Substrate

A 6-inch Si wafer attached with a thermal oxide film consisting of $SiO_2$ was used as the substrate.

Lower electrode layer

Before the film formation of the lower electrode layer, a film of 20 nm of TiW was formed on the thermal oxide film of the substrate as an intimate attachment layer. Then, a film of 150 nm of Ir was formed on a TiW layer as the lower electrode layer under the conditions of an Ar gas of 60 sccm, an RF power of 300 W, and a film formation pressure of 0.25 Pa.

Piezoelectric film

A PZT film doped with Nb, having a thickness of substantially 2 $\mu$m was, formed as the piezoelectric film on the lower electrode layer with a radio frequency (RF) sputter. A PZT target doped with Nb was used. The oxygen isotopes in the oxygen in the target are present at a natural abundance ratio. The substrate set temperature at the time of film formation was 650°C, the film forming gas was 80 sccm of Ar gas and 1 sccm of oxygen, the film formation pressure was 0.18 Pa, and the RF power was 500 W. In each example of Comparative Example 1 and Examples 1 to 5, the ratios of the oxygen atom $^{16}O$ having a mass number of 16 and the oxygen atom $^{18}O$ having a mass number of 18 in 1 sccm of oxygen were changed. The flow rates of $^{16}O$ and $^{18}O$ in each example are shown in Table 1.

Upper electrode layer

An ITO layer having a thickness of 100 nm was formed by sputtering on the piezoelectric film of the above-described laminated substrate.

Measurement of oxygen profile in piezoelectric film

The distributions of $^{18}O$ and $^{16}O$ included in the oxygen in the piezoelectric film were measured by the SIMS analysis. As one example, the data obtained according to the SIMS analysis using a sample of Example 5 is shown in Fig. 2. The sample was irradiated with an $Ar^+$ ion, and the analysis was carried out while cutting the sample from the surface side of the piezoelectric film.

In Fig. 2, the horizontal axis is the position in the thickness direction of the piezoelectric film, 0 is the surface position of the piezoelectric film, and the closer to the side on the right of the horizontal axis is, the closer to the substrate is. $SiO_2$ in the drawing is a thermal oxide film of a substrate, and a lower electrode layer is present between the piezoelectric film having a thickness of substantially 2 $\mu$m and the substrate. In the drawing, a broken line indicates $^{16}O$ and a solid line indicates $^{18}O$. Here, the ratio of $^{16}O$ and the ratio of $^{18}O$ to the sum of $^{16}O$ and $^{18}O$ are shown, respectively. That is, in addition to $^{16}O$ and $^{18}O$, $^{17}O$ having a mass number of 17 is present as a stable isotope of oxygen. The natural abundance ratio is 99.757% for $^{16}O$, 0.038% for $^{17}O$, and 0.205% for $^{18}O$. As a result, a trace amount of $^{17}O$ is present although $^{17}O$ is also contained in the piezoelectric film 15, and thus $^{17}O$ is not considered here.

In Example 5, the substantial ratio of $^{16}O$ to $^{18}O$ was substantially constant over the entire region of the piezoelectric film, and the ratio of $^{18}O$ to the sum of $^{16}O$ and $^{18}O$ was 12%. In the $SiO_2$ in thermal oxide film of the substrate, the ratios of $^{16}O$ and $^{18}O$ were respectively the natural abundance ratios thereof, that is, 99.8% for $^{16}O$ and 0.2% for $^{18}O$. From this point, it is revealed that the $^{18}O$ allowed to flow as a part of the film forming gas at the time of film formation is incorporated in the piezoelectric film.

Similar data were acquired for Comparative Examples 1 and Examples 1 to 4 to determine the ratio of $^{18}O$. The results are shown in Table 1.

Measurement of piezoelectric constant

Preparation of measurement sample

A strip-shaped portion having a size of 2 mm $\times$ 25 mm was cut out from the laminated substrate to produce a cantilever.

Measurement

According to the method described in I. Kanno et. al. Sensor and Actuator A 107 (2003) 68, the piezoelectric constant $d_{31}$ [pm/V] was measured using the cantilever, by using an applied voltage of a sine wave of -10 V ± 10 V, that is, a bias voltage of -10 V and an applied voltage of a sine wave having an amplitude of 10 V The measurement results are shown in Table 1.

Measurement of dielectric breakdown voltage

Preparation of measurement sample

The laminated substrate was subjected to dicing processing to a size of one-inch (25 mm) square to produce a piezoelectric laminate of one-inch square. It is noted that at the time of film formation of the upper electrode layer, a metal mask partially having a circular opening having a diameter of 400 μm was used to form a circular upper electrode layer having a diameter of 400 μm. Then, a one-inch square in which a circular upper electrode layer was provided at the center was cut out and used as a sample for the measurement of the dielectric breakdown voltage.

Measurement

The lower electrode layer was grounded, a negative voltage was applied to the upper electrode layer at a rate of change of -1 V/sec, and a voltage at which a current of 1 mA or more flowed was regarded as the dielectric breakdown voltage. Ten samples were prepared for each example, the measurements were carried out a total of 10 times, and an average value (in terms of absolute value) therefrom is shown in Table 1 as the dielectric breakdown voltage [V].

Table 1

| | Flow rate of flow at time of formation of piezoelectric film | | Piezoelectric characteristics | | |
| --- | --- | --- | --- | --- | --- |
| | $^{16}O$ [sccm] | $^{18}O$ [sccm] | Piezoelectric constant $d_{31}$ [pm/V] | Dielectric breakdown voltage [V] | $^{18}O/(^{16}O + ^{18}O)$ [%] |
| Comparative Example 1 | 1 | 0 | 221.8 | 51.0 | 0.2 |
| Example 1 | 0.8 | 0.2 | 222.0 | 55.6 | 2.6 |
| Example 2 | 0.6 | 0.4 | 224.1 | 61.2 | 4.9 |
| Example 3 | 0.4 | 0.6 | 224.9 | 67.3 | 7.3 |
| Example 4 | 0.2 | 0.8 | 226.2 | 74.9 | 9.6 |
| Example 5 | 0 | 1 | 227.2 | 79.5 | 12 |

Comparative Example 1 does not use $^{18}O$ as the oxygen to be allowed to flow. In this case, $^{18}O$ is present in the oxygen constituting the piezoelectric film at a natural abundance ratio. As a result, the ratio of $^{18}O$ to the sum of $^{16}O$ and $^{18}O$ in the piezoelectric film of Comparative Example 1 was 0.2%. Comparative Example 1 corresponds to a piezoelectric element in the related art.

In Examples 1 to 5, $^{18}O$ is included in the oxygen to be allowed to flow at the time of the formation of the piezoelectric film. Examples 1 to 5 differ in the flow rate of $^{18}O$ at the time of film formation. It is conceived that the larger the flow rate of $^{18}O$ is, the larger the ratio of $^{18}O$ in the piezoelectric film is, whereby a part of the oxygen in the target is replaced with $^{18}O$ at the time of film formation. In Example 5, in which all the oxygen allowed to flow during the film formation was $^{18}O$, the ratio of $^{18}O$ was 12%.

Although the piezoelectric constant was larger than that of Comparative Example 1, it did not increase significantly. On the other hand, the dielectric breakdown voltage increased by about 9% as compared with Comparative Example 1 even in Example 1 in which the flow rate of $^{18}O$ was the lowest, and it increased by 1.5 times in Example 5 in which all the oxygen to be allowed to flow was $^{18}O$, as compared with Comparative Example 1. From these results, it is revealed that the effect of improving the dielectric breakdown voltage by including $^{18}O$ in the piezoelectric film in excess of the natural abundance ratio is exhibited.

According to Table 1, as the ratio of $^{18}O$ in the piezoelectric film is increased from 0.2% to 12%, the dielectric breakdown voltage also is increased. As a result, in a case where the ratio of $^{18}O$ in the piezoelectric film is increased to more than 12%, it is expected that the dielectric breakdown voltage further is increased. It is noted that although the oxygen having stable isotopes having a natural abundance ratio is used in present Example as the oxygen of the target, the ratio of $^{18}O$ in the piezoelectric film can be further increased by increasing the ratio of $^{18}O$ in the target.

Explanation of References

1: piezoelectric element
5: piezoelectric laminate
10: substrate
12: lower electrode layer
15: piezoelectric film
18: upper electrode layer

**Claims**

1. A piezoelectric laminate (5) comprising, on a substrate (10) in the following order:

   a lower electrode layer (12); and
   a piezoelectric film (15) containing a Pb-containing perovskite-type oxide,
   wherein the piezoelectric film (15) contains an oxygen atom $^{18}O$ having a mass number of 18 in oxygen as a constituent element in excess of a natural abundance ratio.

2. The piezoelectric laminate (5) according to claim 1,
   wherein in the oxygen as the constituent element of the piezoelectric film (15), a ratio of the oxygen atom $^{18}O$ to a sum of an oxygen atom $^{16}O$ having a mass number of 16 and the oxygen atom $^{18}O$ is 1% or more.

3. The piezoelectric laminate (5) according to claim 1,
   wherein in the oxygen as the constituent element of the piezoelectric film (15), a ratio of the oxygen atom $^{18}O$ to a sum of an oxygen atom $^{16}O$ having a mass number of 16 and the oxygen atom $^{18}O$ is 5% or more and 15% or less.

4. The piezoelectric laminate (5) according to any one of claims 1 to 3,
   wherein the Pb-containing perovskite-type oxide contains Zr, Ti, and O, in addition to Pb.

5. The piezoelectric laminate (5) according to claim 4,
   wherein the Pb-containing perovskite-type oxide contains Nb.

6. The piezoelectric laminate (5) according to claim 5,
   wherein the Pb-containing perovskite-type oxide is a compound represented by General Formula (1),

   $$Pb\{(Zr_xTi_{1-x})_{y-1}Nb_y\}O_3 \qquad (1)$$

   $$0 < x < 1,\ 0.1 \leq y \leq 0.4.$$

7. The piezoelectric laminate (5) according to any one of claims 1 to 3, wherein the piezoelectric film (15) is a sputter film.

8. A piezoelectric element (1) comprising:

   the piezoelectric laminate (5) according to any one of claims 1 to 7; and
   an upper electrode layer (18) provided on the piezoelectric film (15) of the piezoelectric laminate (5).

9. A manufacturing method for a piezoelectric laminate (5), which is the manufacturing method for the piezoelectric laminate (5) according to any one of claims 1 to 7, comprising:

a sputtering step of forming the piezoelectric film (15) through sputter film formation on the lower electrode layer (12) formed on the substrate (10),

wherein in the sputtering step, oxygen including an oxygen atom $^{18}O$ having a mass number of 18 at a ratio larger than a natural abundance ratio is allowed to flow as a part of a film forming gas.

# FIG. 1

# FIG. 2

LOWER ELECTRODE LAYER

PIEZOELECTRIC FILM          SiO₂

THICKNESS DIRECTION [μm]

Europäisches
Patentamt

European
Patent Office

Office européen
des brevets

# EUROPEAN SEARCH REPORT

**Application Number**

EP 23 15 4669

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AYGUAVIVES F. ET AL: "Oxygen transport during annealing of Pb(Zr,Ti)O 3 thin films in O 2 gas and its effect on their conductivity", JOURNAL OF MATERIALS RESEARCH, vol. 16, no. 10, 31 October 2001 (2001-10-31), pages 3005-3008, XP93063053, US ISSN: 0884-2914, DOI: 10.1557/JMR.2001.0412 | 1,2,4, 7-9 | INV. H10N30/076 H10N30/00 H10N30/853 H10N30/87 |
| A | * page 3005, right-hand column, last paragraph - page 3006, right-hand column, paragraph 3; figure 2 * | 3,5,6 | |
| A | HOLZLECHNER G ET AL: "Oxygen vacancy redistribution in PbZrxTi1-xO3(PZT) under the influence of an electric f", SOLID STATE IONICS, vol. 262, 9 January 2014 (2014-01-09), pages 625-629, XP028855763, ISSN: 0167-2738, DOI: 10.1016/J.SSI.2013.08.027 * Sections 2 and 3; figures 1-3 * | 1-9 | |

**TECHNICAL FIELDS SEARCHED (IPC)**

H10N

The present search report has been drawn up for all claims

| Place of search | Date of completion of the search | Examiner |
|---|---|---|
| Munich | 12 July 2023 | Steiner, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017162906 A

- JP 2006086223 A